# FASCICULE DE BREVET EUROPEEN

(11) **EP 2 145 237 B1**
(45) Date de publication et mention de la délivrance du brevet: **21.12.2016**
(21) Numéro de dépôt: 08709821.6
(22) Date de dépôt: 15.02.2008
(51) Int. Cl.: G04B 17/06, G04B 5/16, G04B 13/02, G04F 7/08, G04D 3/00

(54) **COMPOSANT HORLOGER ET SON PROCÉDÉ DE FABRICATION**
UHRENKOMPONENTE UND VERFAHREN ZU IHRER HERSTELLUNG
TIMEPIECE COMPONENT AND METHOD FOR MAKING SAME

(30) Priorité: 08.05.2007 CH 748072007
(43) Date de publication de la demande: 20.01.2010
(73) Titulaire: Patek Philippe SA Genève, 1204 Genève (CH)
(72) Inventeur: MAIER, Frédéric, CH-2000 Neuchâtel (CH); VON GUNTEN, Stéphane, CH-2300 La Chaux-de-Fonds (CH); JEANNERET, Sylvain, CH-2013 Colombier (CH)
(74) Mandataire: Micheli & Cie SA
(86) Numéro de dépôt international: PCT/IB2008/000345
(87) Numéro de publication internationale: WO 2008/135817

(56) Documents cités:
- EP-A- 0 732 635
- EP-A- 0 957 414
- EP-A- 1 655 642
- EP-A- 1 850 193
- CH-A- 339 868
- CH-D- 1 751 771
- FR-A- 1 275 357

## Description

La présente invention concerne un composant horloger et son procédé de fabrication.

Plus particulièrement, la présente invention concerne un composant horloger réalisé au moyen d'une technique de micro-fabrication.

Certains composants horlogers, à savoir des spiraux et des roues, sont aujourd'hui fabriqués en silicium. Le silicium est apprécié pour sa légèreté, son élasticité, son caractère amagnétique et pour son aptitude à être usiné par des techniques de micro-fabrication, en particulier par la technique de gravure ionique réactive profonde DRIE.

Le silicium présente néanmoins des inconvénients : il est fragile, en d'autres termes il ne présente pas de domaine plastique, ce qui rend difficile par exemple la fixation d'une roue en silicium sur un axe. De plus, sa grande légèreté ne permet pas de réaliser complètement en silicium, et dans de petites dimensions, des composants tels qu'un balancier ou une masse oscillante qui doivent avoir une inertie ou un balourd suffisants.

D'autres matériaux que le silicium, eux aussi usinables par des techniques de micro-fabrication, et dont l'utilisation pour fabriquer des composants horlogers peut être envisagée, présentent les mêmes inconvénients. Ces matériaux sont notamment le diamant, le quartz, le verre et le carbure de silicium.

On connaît par le document EP-A-0 957 414 une masse de remontage oscillante constituée par un assemblage d'une partie pesante périphérique, d'un moyeu et d'un disque de liaison reliant la partie pesante périphérique et le moyeu. La partie pesante périphérique est faite en métal et le disque de liaison est en un matériau transparent tel que le saphir. La partie pesante périphérique et le disque de liaison sont assemblés par collage, vissage, rivetage ou analogue. Le moyeu est chassé dans un trou central du disque de liaison. Un tel composant horloger présente un risque de rupture de son disque de liaison lors de la fabrication, en particulier lors du chassage du moyeu dans le disque de liaison. De plus, du fait qu'il est obtenu par un assemblage de pièces, sa précision de fabrication est limitée.

La présente invention vise à permettre la micro-fabrication de composants horlogers pour des applications qui jusque-là n'étaient pas envisageables du fait des inconvénients précités des matériaux utilisés.

A cette fin, il est prévu un composant horloger comprenant une structure pouvant être réalisée par une technique de micro-fabrication et au moins un élément fait dans un matériau différent de celui de la structure, le matériau dudit élément étant métallique, caractérisé en ce que ledit élément est électro-formé dans la structure ou à la périphérie de la structure.

L'élément précité peut modifier les propriétés mécaniques du composant pour rendre ce dernier utilisable dans une application donnée tout en conservant les avantages du matériau utilisé pour réaliser la structure. Cet élément peut par exemple servir à augmenter le rapport inertie/masse d'un balancier ou le rapport balourd/masse d'une masse oscillante, ou à absorber localement une partie des contraintes générées par le chassage d'un axe. On notera que l'élément précité est formé, et non pas rapporté, dans ou à la périphérie de la structure. Tout le composant horloger peut donc être fabriqué par des techniques de micro-fabrication, c'est-à-dire des techniques permettant une précision de l'ordre du micron. L'élément précité ne nuit donc pas à la précision de fabrication du composant.

Des modes de réalisation particuliers du composant horloger selon l'invention sont définis dans les revendications annexées 2 à 11.

La présente invention propose également un procédé de fabrication d'un composant horloger, comprenant une étape de réalisation d'une structure par une technique de micro-fabrication, caractérisé en ce qu'il comprend en outre une étape consistant à électro-former au moins un élément dans la structure ou à la périphérie de la structure, ledit élément étant métallique et dans un matériau différent de celui de la structure, de sorte que le composant horloger final comprenne ladite structure et ledit élément.

Des modes de réalisation particuliers de ce procédé sont définis dans les revendications annexées 13 à 25.

D'autres caractéristiques et avantages de la présente invention apparaîtront à la lecture de la description détaillée suivante de plusieurs modes de réalisation de l'invention faite en référence aux dessins annexés dans lesquels :
- les figures 1 et 2 sont respectivement une vue plane de dessus et une vue en coupe axiale d'un balancier selon l'invention ;
- la figure 3 est une vue en perspective d'une masse oscillante selon l'invention ;
- les figures 4 et 5 sont respectivement une vue plane de dessus et une vue en coupe axiale d'une roue selon l'invention ;
- la figure 6 est une vue en perspective d'une masse oscillante selon un autre mode de réalisation;
- la figure 7 montre schématiquement un procédé de fabrication d'un composant horloger tel que ceux illustrés aux figures 1 à 3 ;
- la figure 8 montre schématiquement un procédé de fabrication d'un composant horloger tel que celui illustré aux figures 4 et 5 ;
- la figure 9 montre schématiquement un procédé de fabrication d'une roue et d'un pignon ; et
- la figure 10 montre schématiquement un procédé de fabrication de la masse oscillante illustrée à la figure 6.

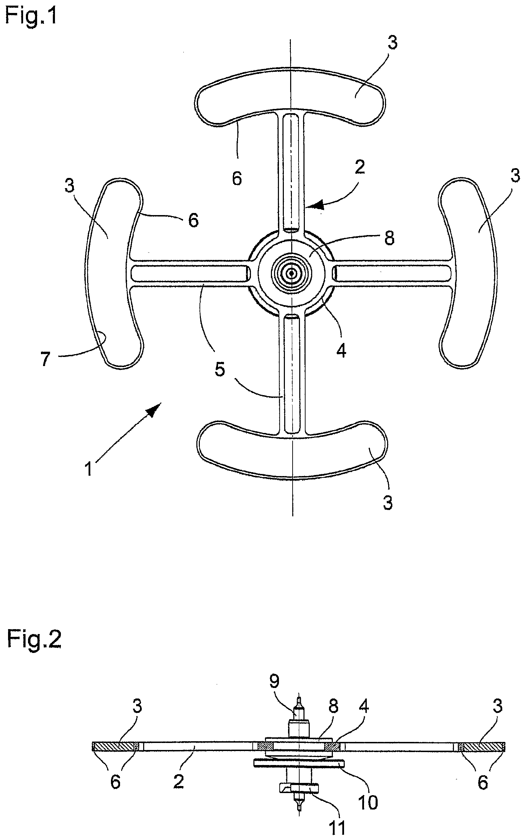

En référence à la figure 1, un balancier 1 selon l'invention pour un mouvement d'horlogerie comprend une structure principale en silicium 2 et des éléments métalliques 3. La structure en silicium 2 comprend une partie centrale annulaire 4, des bras 5 qui s'étendent radialement depuis la partie centrale 4 et, à l'extrémité de ces bras 5, des contours fermés 6 qui définissent des cavités traversantes 7 par exemple en forme de haricot. Les cavités 7 sont remplies par les éléments métalliques 3, respectivement, et forment avec ces éléments 3 des segments de serge disjoints.

Les éléments métalliques 3 sont dans un matériau de plus grande masse volumique que le silicium. Ils alourdissent donc la périphérie du balancier 1 et augmentent l'inertie de ce dernier pour atteindre une inertie souhaitée. La partie intérieure du balancier 1, formée par la partie centrale 4 et les bras 5, est elle très légère du fait qu'elle est réalisée en silicium et qu'elle est très évidée. Comme la partie intérieure d'un balancier contribue moins à l'inertie que la partie périphérique, un grand rapport inertie/masse peut être obtenu. Ainsi, pour une même inertie qu'un balancier traditionnel métallique, la masse totale du balancier 1 est plus petite. Ceci a pour avantage, notamment, de diminuer les frottements des pivots de l'axe du balancier dans les paliers.

Dans une variante de réalisation, la serge pourrait être continue, c'est-à-dire que les segments de serge 3, 6 pourraient se toucher.

Les éléments métalliques 3 sont typiquement en or. Ils pourraient néanmoins être faits dans un autre métal, en particulier un autre métal à masse volumique élevée, tel que le platine.

La structure en silicium 2 et les éléments métalliques 3 sont réalisés par des techniques de micro-fabrication ou micro-formage. Le balancier 1 peut donc être fabriqué avec une grande précision. Son inertie sera donc précise, ce qui facilitera son appairage avec un ressort-spiral pour obtenir une fréquence souhaitée pour le dispositif régulateur balancier-spiral du mouvement horloger. Un exemple de procédé de fabrication du balancier 1 sera décrit plus loin.

Comme représenté à la figure 2, les éléments métalliques 3 sont dans le même plan que la structure en silicium 2 et ont la même hauteur, constante, que cette dernière. De cette manière, les éléments métalliques 3 peuvent occuper un grand volume sans augmenter la hauteur du balancier 1. En variante, néanmoins, les éléments métalliques 3 pourraient déborder au-delà des cavités 7 pour, par exemple, renforcer la tenue de ces éléments 3 dans la structure en silicium 2.

Le montage du balancier 1 sur son axe peut être effectué, comme montré aux figures 1 et 2, en plaçant dans la partie centrale 4 de la structure en silicium 2 une pièce annulaire 8 faite dans un matériau métallique mou, tel que l'or, et en chassant l'axe du balancier, désigné par le repère 9, dans cette pièce annulaire 8. La pièce annulaire 8 est dimensionnée pour se déformer lors du chassage de l'axe 9 et ainsi absorber une partie des contraintes exercées par l'axe 9 pour éviter une rupture du silicium. A la figure 2, les repères 10 et 11 désignent le grand plateau et le petit plateau de l'échappement.

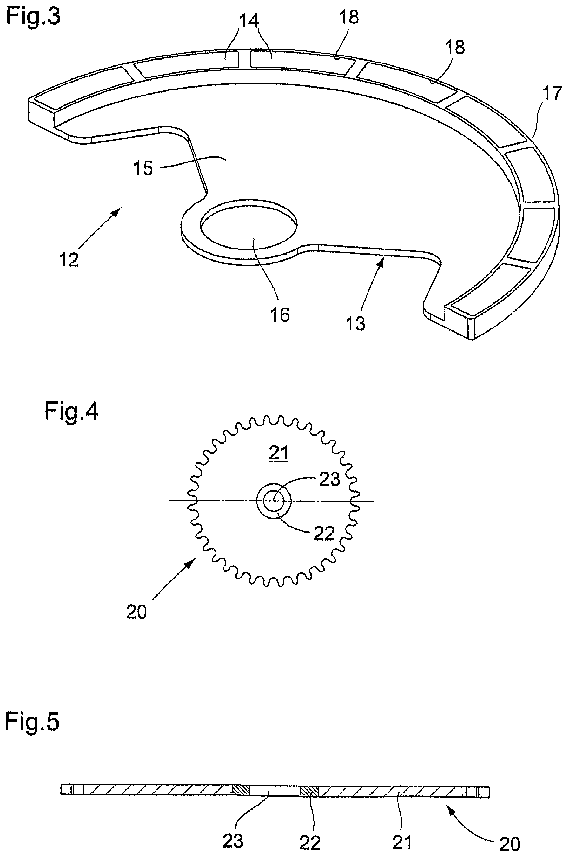

En référence à la figure 3, une masse oscillante 12 selon l'invention pour un mécanisme de remontage automatique d'une pièce d'horlogerie comprend une structure principale en silicium 13 et des éléments métalliques 14. La structure en silicium 13 comprend une partie principale mince 15 comprenant un trou 16 pour le montage de la masse oscillante 12 sur un axe ou un roulement à billes et une partie périphérique plus épaisse 17. Le montage de la masse oscillante 12 sur son axe ou son roulement à billes peut être effectué de la même manière que pour le balancier 1, c'est-à-dire au moyen d'une pièce intermédiaire en un matériau mou.

Les éléments métalliques 14 remplissent des cavités traversantes respectives 18 de la partie périphérique épaisse 17. Les éléments métalliques 14 sont dans un matériau de plus grande masse volumique que le silicium, par exemple en or ou en platine. Ils alourdissent donc la périphérie de la masse oscillante 12 et augmentent son balourd pour obtenir un balourd souhaité. La partie intérieure 15 de la masse oscillante 12 est elle très légère car réalisée en silicium et mince. Cette partie intérieure 15 pourrait être évidée pour être rendue encore plus légère. Comme la partie intérieure d'une masse oscillante contribue moins au balourd que la partie périphérique, un grand rapport balourd/masse peut être obtenu. Ainsi, pour un même balourd qu'une masse oscillante traditionnelle métallique, la masse totale de la masse oscillante 10 est plus petite. Ceci a pour avantage, notamment, de diminuer les frottements. Un exemple de procédé de fabrication de la masse oscillante 12 sera décrit plus loin.

En référence aux figures 4 et 5, une roue dentée 20 selon l'invention pour un mécanisme horloger comprend une structure principale en silicium 21 et un élément métallique annulaire 22 formé dans une cavité traversante centrale de la structure 21. Le trou central 23 de l'élément 22 permet le passage d'un axe. Le diamètre de ce trou central 23 est choisi inférieur au diamètre de l'axe de sorte à permettre le montage de la roue 20 sur l'axe par chassage. Comme le matériau dans lequel est fait l'élément 22, par exemple de l'or ou du nickel, présente une grande déformabilité, à la différence du silicium, une partie des contraintes exercées par l'axe sera absorbée par l'élément 22, ce qui évitera une rupture du silicium. Un élément du type de l'élément 22 constitue donc un moyen d'absorber localement des contraintes de chassage, ceci sans nuire à la précision de fabrication du composant, puisque, comme on le verra plus loin, l'élément 22 peut être formé par une technique de micro-fabrication ou micro-formage.

On notera qu'un élément métallique du type de l'élément 22 illustré aux figures 4, 5 pourrait aussi être formé dans la cavité centrale de la structure en silicium du balancier 1 ou de la masse oscillante 12 et remplacer la pièce annulaire 8.

Par ailleurs, dans l'exemple représenté, l'élément 22 a la même hauteur que la structure en silicium 21. Dans une variante de réalisation, l'élément 22 pourrait avoir une plus grande hauteur que la structure 21 pour par exemple définir un pignon coaxial à la roue 20 et solidaire de cette dernière. Un exemple de procédé de réalisation de cette variante sera décrit plus loin.

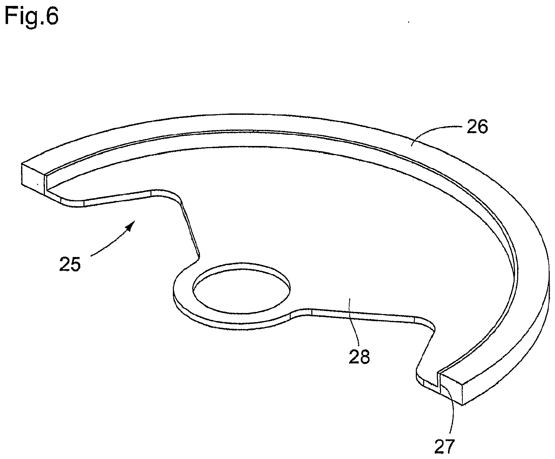

La figure 6 montre une masse oscillante 25 selon une variante de réalisation de l'invention. Cette masse oscillante 25 diffère de la masse oscillante 12 illustrée à la figure 3 en ce que les éléments métalliques 14 sont remplacés par un élément métallique 26 formé sur une surface périphérique 27 de la structure principale en silicium, désignée par le repère 28. L'élément 26 a une forme en arc de cercle et s'étend sur toute la longueur et toute la hauteur de la surface 27. Pour renforcer la liaison entre l'élément 26 et la structure en silicium 28, on peut prévoir sur la surface périphérique 27 des protubérances d'ancrage noyées dans l'élément 26. Un exemple de procédé de fabrication de la masse oscillante 25 sera décrit plus loin. De manière similaire à l'élément 26, un élément métallique circulaire pourrait être formé sur une surface périphérique d'une structure en silicium, de manière continue ou discontinue, pour fabriquer un balancier, par exemple.

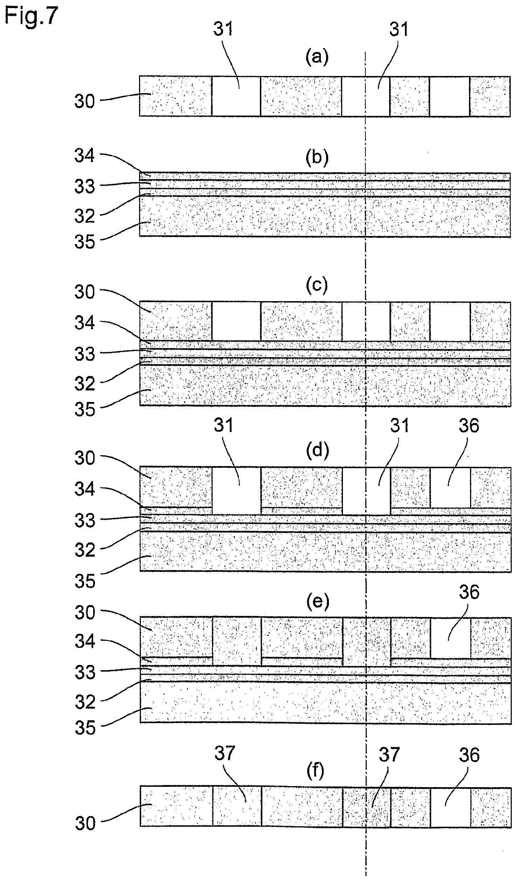

La figure 7 montre schématiquement un exemple de procédé de fabrication des composants illustrés aux figures 1, 2 et 3. A une première étape (figure 7a), la structure en silicium 30 du composant, avec sa ou ses cavités 31, est réalisée par gravure ionique réactive profonde DRIE (Deep Reactive Ion Etching). Pour simplifier, la structure 30 est représentée comme n'ayant qu'une seule hauteur. Dans le cas du balancier 1, une seule étape de DRIE est nécessaire. Dans le cas de la masse oscillante 12, deux étapes de DRIE sont pratiquées pour réaliser la partie mince 15 et la partie épaisse 17. A une seconde étape (figure 7b), une première couche de résine photosensible 32, une couche métallique 33 et une seconde couche de résine photosensible 34 sont successivement formées sur une plaquette de support 35 en silicium ou en pyrex, par exemple. A une troisième étape (figure 7c), la plaquette de support 35 avec ses couches 32, 33, 34 et la structure en silicium 30 sont assemblées par collage, la couche de résine photosensible 34 servant de colle. A une quatrième étape (figure 7d), les parties exposées de la résine photosensible 34, c'est-à-dire les parties se trouvant en regard des cavités 31, sont enlevées par un procédé photolithographique en utilisant la structure en silicium 30 comme masque. A une cinquième étape (figure 7e), du métal est formé dans les cavités 31 par électro-formage (croissance galvanique) à partir des parties exposées de la couche métallique 33 et en utilisant les parois en silicium des cavités 31 comme moules. Ensuite, la plaquette 35 et les couches 32, 33, 34 sont enlevées (figure 7f), laissant la structure en silicium 30 avec des éléments métalliques 37 formés dans ses cavités initiales 31, et une opération de mise à niveau est pratiquée, par exemple par rodage, pour donner aux éléments 37 la même hauteur que la structure 30.

Pendant les quatrième et cinquième étapes, certaines zones 36 peuvent être épargnées de manière connue en soi pour ne pas subir l'électro-formage. Ces zones 36 sont par exemple des espaces vides entre des parties en silicium qui ont été laissées lors de la gravure DRIE pour constituer des attaches maintenant la structure 30 attachée à d'autres structures réalisées simultanément dans une même plaquette. Ces attaches sont cassées à la fin du procédé de fabrication pour séparer les composants.

L'assemblage de la plaquette de support 35 et de la structure en silicium 30 (troisième étape ; figure 7c) peut être réalisé d'une autre manière que décrit ci-dessus, par exemple par thermo-compression de la couche de métal 33 contre la structure 30 (dans ce cas, la couche de résine photosensible 34 est omise) ou en remplaçant la couche de résine photosensible 34 par de l'oxyde de silicium liquide séché.

Plus de détails concernant le procédé décrit ci-dessus peuvent être trouvés dans l'article de Debbie G. Jones et Albert P. Pisano intitulé « Fabrication of ultra thick ferromagnetic structures in silicon », Proceedings of IMECE04, 2004 ASME International Mechanical Engineering Congress and Exposition, 13-20 novembre 2004, Anaheim, California USA, dans lequel un procédé similaire est décrit pour fabriquer des structures ferromagnétiques dans du silicium.

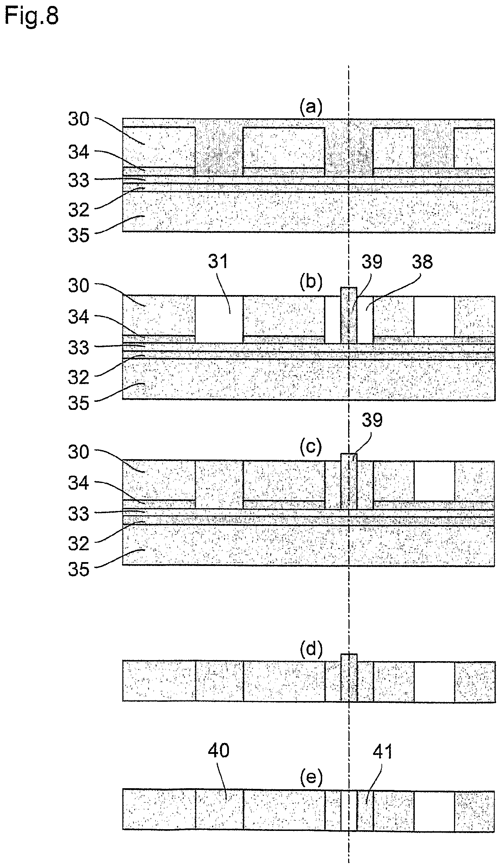

La figure 8 montre schématiquement comment peut être réalisé un élément métallique central annulaire du type de l'élément 22 illustré aux figures 4 et 5. La figure 8 montre plus précisément comment réaliser cet élément central simultanément avec des éléments périphériques. Les quatre premières étapes sont similaires aux étapes des figures 7a à 7d, respectivement. Une cinquième étape, représentée à la figure 8a, consiste à remplir les cavités 31 de la structure en silicium 30 d'une résine photosensible telle qu'une résine SU-8. Une sixième étape (figure 8b) consiste à enlever cette résine SU-8 par un procédé photolithographique, sauf dans une partie centrale de la cavité centrale 38 correspondant au trou de l'élément métallique central. Une septième étape (figure 8c) consiste à former du métal dans les cavités 31, 38. Dans la cavité centrale 38, ce métal ne se forme qu'autour de la partie restante 39 de la résine SU-8. Ensuite, on retire la plaquette de support 35 avec ses couches 32, 33, 34 (figure 8d) puis on élimine la partie restante 39 de la résine SU-8 (figure 8e). On obtient ainsi un ou des éléments métalliques périphériques 40, qui servent par exemple à augmenter l'inertie du composant, et un élément annulaire central 41 permettant le chassage d'un axe, par exemple.

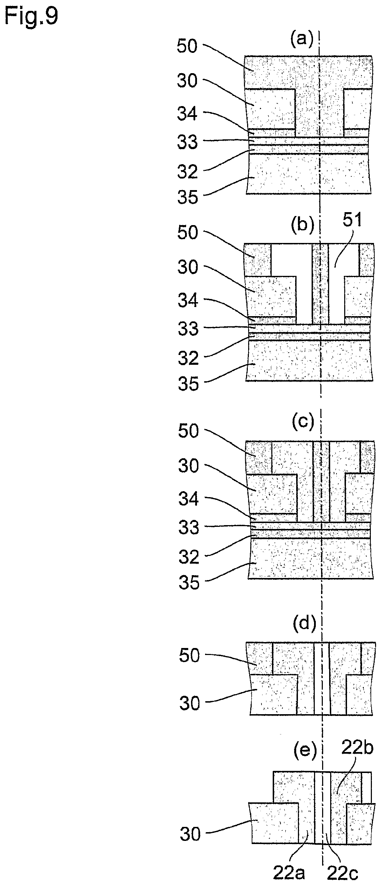

La figure 9 montre schématiquement un exemple de procédé de réalisation d'un composant comprenant un élément métallique central annulaire du type de l'élément 22 illustré aux figures 4 et 5 mais ayant une plus grande hauteur pour définir un pignon. Les quatre premières étapes sont similaires aux étapes des figures 7a à 7d respectivement. Une cinquième étape, représentée à la figure 9a, consiste à former de la résine photosensible SU-8 50 dans la cavité centrale de la structure en silicium 30 et au-delà de cette cavité, sur la face supérieure de la structure en silicium 30. Une sixième étape (figure 9b) consiste à photo-structurer la résine photosensible 50 de manière à définir avec la structure en silicium 30 une cavité 51 ayant la forme de l'élément central annulaire et de son pignon. Une septième étape (figure 9c) consiste à électro-former du métal dans la cavité 51. Puis la plaquette de support 35 avec ses couches 32, 33, 34 et la résine photosensible 50 sont enlevées (figures 9d et 9e), laissant une structure en silicium 30 et un élément métallique annulaire 22a formé dans la structure 30 et débordant de cette structure 30 pour définir un pignon 22b. L'ensemble 22a, 22b est traversé par un trou central 22c dans lequel peut être chassé un axe. Dans des variantes, l'élément annulaire 22a pourrait définir d'autres éléments qu'un pignon, par exemple une came ou un coeur de chronographe.

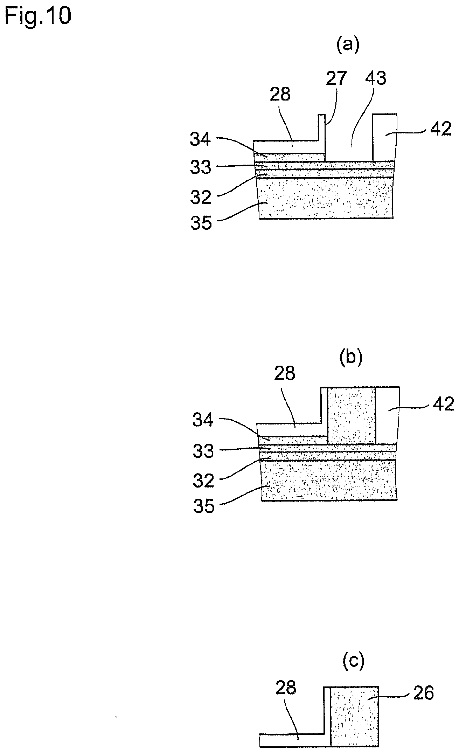

La figure 10 montre schématiquement comment peut être formé l'élément métallique 26 de la masse oscillante 25 illustrée à la figure 6. A des premières étapes (figure 10a), la structure en silicium 28 est réalisée par deux étapes de gravure DRIE, une plaquette de support 35 avec des couches successives de résine photosensible 32, métal 33 et résine photosensible 34 est assemblée à la structure 28, la partie de la résine photosensible 34 située à l'extérieur de la structure 28 est enlevée pour exposer la couche métallique 33, puis une partie de résine photosensible SU-8 42 est formée à l'extérieur de la structure 28, de manière similaire à la partie 39 de la figure 8, pour former une cavité 43 avec la structure en silicium 28. A une étape suivante (figure 10b), du métal est électro-formé dans la cavité 43. A des étapes suivantes (figure 10c), la plaquette 35 avec ses couches 32, 33, 34 puis la résine 42 sont enlevées.

Dans tous les procédés décrits ci-dessus, la structure en silicium est en principe recouverte d'une couche d'oxyde de silicium avant l'étape d'électro-formage. Cette couche résulte de l'oxydation naturelle du silicium. Son épaisseur peut être augmentée en plaçant la structure en silicium dans un four d'oxydation avant l'électro-formage. L'oxyde de silicium améliore en effet certaines caractéristiques mécaniques du silicium, telles que le coefficient de frottement ou la résistance mécanique. D'autres revêtements peuvent également être déposés sur la structure en silicium si cela est souhaité. On comprendra donc que les éléments métalliques ne sont pas nécessairement directement en contact avec le silicium, mais peuvent être en contact avec des parois en oxyde de silicium ou avec un revêtement particulier.

Outre sa grande précision, on appréciera que les procédés de fabrication des composants selon l'invention décrits ci-dessus permettent de réaliser un grand nombre de composants simultanément à partir d'une même plaquette.

Bien que l'invention ait été décrite ci-dessus pour des structures en silicium, elle pourrait être appliquée à d'autres matériaux usinables par des techniques de micro-fabrication, notamment par la technique DRIE, comme le diamant, le quartz, le verre ou le carbure de silicium.

## Revendications

1. Composant horloger comprenant une structure (2 ; 13 ; 21 ; 28) pouvant être réalisée par une technique de micro-fabrication et au moins un élément (3 ; 14 ; 22 ; 26) fait dans un matériau différent de celui de la structure, le matériau dudit élément étant métallique, **caractérisé en ce que** ledit élément est électro-formé dans la structure ou à la périphérie de la structure.

2. Composant horloger selon la revendication 1, **caractérisé en ce que** la structure est en silicium.

3. Composant horloger selon la revendication 1, **caractérisé en ce que** la structure est en diamant, quartz, verre ou carbure de silicium.

4. Composant horloger selon l'une quelconque des revendications 1 à 3, **caractérisé en ce que** ledit élément (3 ; 14 ; 22) remplit une cavité de la structure (2 ; 13 ; 21).

5. Composant horloger selon l'une quelconque des revendications 1 à 4, **caractérisé en ce que** ledit élément (3 ; 14 ; 22 ; 26) est dans un même plan et a la même hauteur que la structure (2 ; 13 ; 21 ; 28).

6. Composant horloger selon l'une quelconque des revendications 1 à 4, **caractérisé en ce que** ledit élément (22a, 22b) fait saillie hors du plan de la structure (30).

7. Composant horloger selon l'une quelconque des revendications 1 à 6, **caractérisé en ce qu'**il consiste en un balancier (1) et **en ce que** ledit élément (3) est situé à la périphérie de la structure (2) et sert à augmenter le rapport inertie/masse du balancier.

8. Composant horloger selon l'une quelconque des revendications 1 à 6, **caractérisé en ce qu'**il consiste en une masse oscillante (12 ; 25) pour remontage automatique et **en ce que** ledit élément (14 ; 26) est situé à la périphérie de la structure (13 ; 28) et sert à augmenter le rapport balourd/masse de la masse oscillante.

9. Composant horloger selon l'une quelconque des revendications 1 à 6, **caractérisé en ce qu'**il est destiné à être chassé sur un organe de support et **en ce que** ledit élément (22) comprend un trou central (23) destiné à recevoir cet organe de support.

10. Composant horloger selon les revendications 6 et 9, **caractérisé en ce que** ledit élément (22a) définit un pignon (22b), une came ou un coeur de chronographe en dehors du plan de la structure (30).

11. Composant horloger selon la revendication 9 ou 10, **caractérisé en ce qu'**il consiste en un balancier (1), une masse oscillante ou une roue (20).

12. Procédé de fabrication d'un composant horloger, comprenant une étape de réalisation d'une structure (2 ; 13 ; 21 ; 28) par une technique de micro-fabrication, **caractérisé en ce qu'**il comprend en outre une étape consistant à électro-former au moins un élément (3 ; 14 ; 22 ; 26) dans la structure ou à la périphérie de la structure, ledit élément étant métallique et dans un matériau différent de celui de la structure, de sorte que le composant horloger final comprenne ladite structure et ledit élément.

13. Procédé selon la revendication 12, **caractérisé en ce que** l'étape de réalisation de la structure est effectuée en utilisant la technique DRIE.

14. Procédé selon la revendication 12 ou 13, **caractérisé en ce que** la structure est réalisée en silicium.

15. Procédé selon la revendication 12 ou 13, **caractérisé en ce que** la structure est réalisée en diamant, quartz, verre ou carbure de silicium.

16. Procédé selon l'une quelconque des revendications 12 à 15, **caractérisé en ce que** l'étape d'électro-formage dudit élément consiste à déposer ledit matériau dans une cavité (31 ; 38 ; 43 ; 51) définie en partie au moins par la structure (30), en utilisant ladite cavité comme moule.

17. Procédé selon la revendication 16, **caractérisé en ce que** la cavité (31) est définie entièrement par la structure (30).

18. Procédé selon la revendication 16, **caractérisé en ce que** la cavité (38 ; 43 ; 51) est définie partiellement par la structure (30) et partiellement par de la résine photosensible (39 ; 42 ; 50).

19. Procédé selon la revendication 18, **caractérisé en ce que** l'étape d'électro-formage dudit élément (26) consiste à déposer ledit matériau dans une cavité (43) définie par la structure (28) et par de la résine photosensible (42) formée à l'extérieur de la structure (28), de sorte qu'après enlèvement de la résine photosensible (42) un élément (26) soit formé sur une surface périphérique (27) de la structure (28).

20. Application du procédé selon l'une quelconque des revendications 12 à 19 à la fabrication d'un balancier (1), ledit élément (3) étant placé à la périphérie de la structure (2) et servant à augmenter le rapport inertie/masse du balancier.

21. Application du procédé selon l'une quelconque des revendications 12 à 19 à la fabrication d'une masse oscillante (12 ; 25) pour remontage automatique, ledit élément (14 ; 26) étant placé à la périphérie de la structure (13 ; 28) et servant à augmenter le rapport balourd/masse de la masse oscillante.

22. Procédé selon la revendication 18, **caractérisé en ce que** l'étape d'électro-formage dudit élément (22) consiste à déposer ledit matériau dans une cavité (38) de la structure (30) comprenant de la résine photosensible (39) dans sa partie centrale, de sorte qu'après enlèvement de la résine photosensible (39) un élément (22) comprenant un trou central (23) soit formé dans la cavité.

23. Procédé selon la revendication 18 ou 22, **caractérisé en ce que** la cavité (51) s'étend en dehors du plan de la structure (30) et est conformée pour qu'après l'étape d'électro-formage dudit élément (22a) ce dernier définisse un pignon (22b), une came ou un coeur de chronographe.

24. Application du procédé selon la revendication 22 ou selon les revendications 22 et 23 à la fabrication d'un composant horloger (20) destiné à être chassé sur un organe de support, le trou central (23) dudit élément (22) servant à recevoir l'organe de support.

25. Application selon la revendication 24, **caractérisée en ce que** le composant horloger est un balancier, une masse oscillante ou une roue.

## Patentansprüche

1. Uhrenkomponente, umfassend eine Struktur (2; 13; 21; 28), welche mit einem Mikroherstellungsverfahren herstellbar ist, und mindestens ein Element (3; 14; 22; 26), welches aus einem von dem der Struktur unterschiedlichen Material hergestellt ist, wobei das Material des genannten Elementes metallisch ist, **dadurch gekennzeichnet, dass** das genannte Element in der Struktur oder am Umfang der Struktur elektrogeformt ist.

2. Uhrenkomponente nach Anspruch 1, **dadurch gekennzeichnet, dass** die Struktur aus Silizium besteht.

3. Uhrenkomponente nach Anspruch 1, **dadurch gekennzeichnet, dass** die Struktur aus Diamant, Quarz, Glas oder Siliziumkarbid besteht.

4. Uhrenkomponente nach einem beliebigen der Ansprüche 1 bis 3, **dadurch gekennzeichnet, dass** das genannte Element (3; 14; 22) einen Hohlraum der Struktur (2; 13; 21) ausfüllt.

5. Uhrenkomponente nach einem beliebigen der Ansprüche 1 bis 4, **dadurch gekennzeichnet, dass** das genannte Element (3; 14; 22; 26) in derselben Ebene wie die Struktur (2; 13; 21; 28) liegt und die selbe Höhe wie die Struktur (2, 13; 21; 28) hat.

6. Uhrenkomponente nach einem beliebigen der Ansprüche 1 bis 4, **dadurch gekennzeichnet, dass** das genannte Element (22a, 22b) aus der Ebene der Struktur (30) herausragt.

7. Uhrenkomponente nach einem beliebigen der Ansprüche 1 bis 6, **dadurch gekennzeichnet, dass** sie aus einer Unruh (1) besteht und dass sich das genannte Element (3) am Umfang der Struktur (2) befindet und dazu dient, das Verhältnis Trägheit/Masse der Unruh zu vergrößern.

8. Uhrenkomponente nach einem beliebigen der Ansprüche 1 bis 6, **dadurch gekennzeichnet, dass** sie aus einer Schwungmasse (12; 25) für den automatischen Aufzug besteht und dass sich das genannte Element (14; 26) am Umfang der Struktur (13; 28) befindet und dazu dient, das Verhältnis Unwucht/Masse der Schwungmasse zu vergrößern.

9. Uhrenkomponente nach einem beliebigen der Ansprüche 1 bis 6, **dadurch gekennzeichnet, dass** sie dazu bestimmt ist, auf ein Halteorgan getrieben zu werden, und dass das genannte Element (22) ein zentrales Loch (23) umfasst, welches dazu bestimmt ist, dieses Halteorgan aufzunehmen.

10. Uhrenkomponente nach den Ansprüchen 6 und 9, **dadurch gekennzeichnet, dass** das genannte Element (22a) ein Zahnrad (22b), eine Kurvenscheibe oder ein Chronographen-Nullstellherz außerhalb der Ebene der Struktur (30) definiert.

11. Uhrenkomponente nach Anspruch 9 oder 10, **dadurch gekennzeichnet, dass** sie aus einer Unruh (1), einer Schwungmasse oder einem Rad (20) besteht.

12. Verfahren zur Herstellung einer Uhrenkomponente, umfassend einen Schritt zur Fertigung einer Struktur (2; 13; 21; 28) mit einem Mikroherstellungsverfahren, **dadurch gekennzeichnet, dass** es außerdem einen Schritt bestehend aus dem Elektroformen mindestens eines Elementes (3; 14; 22; 26) in der Struktur oder am Umfang der Struktur umfasst, wobei das genannte Element metallisch ist und aus einem von dem der Struktur unterschiedlichen Material besteht, so dass die fertige Uhrenkomponente die genannte Struktur und das genannte Element umfasst.

13. Verfahren nach Anspruch 12, **dadurch gekennzeichnet, dass** der Schritt der Herstellung der Struktur unter Verwendung der DRIE-Technik ausgeführt wird.

14. Verfahren nach Anspruch 12 oder 13, **dadurch gekennzeichnet, dass** die Struktur aus Silizium hergestellt ist.

15. Verfahren nach Anspruch 12 oder 13, **dadurch gekennzeichnet, dass** die Struktur aus Diamant, Quarz, Glas oder Siliziumkarbid hergestellt ist.

16. Verfahren nach einem beliebigen der Ansprüche 12 bis 15, **dadurch gekennzeichnet, dass** der Schritt des Elektroformens des genannten Elements darin besteht, das genannte Material in einem Hohlraum (31; 38; 43; 51) zu deponieren, welcher zumindest teilweise durch die Struktur (30) definiert wird, unter Verwendung des genannten Hohlraums als Gießform.

17. Verfahren nach Anspruch 16, **dadurch gekennzeichnet, dass** der Hohlraum (31) vollständig durch die Struktur (30) definiert wird.

18. Verfahren nach Anspruch 16, **dadurch gekennzeichnet, dass** der Hohlraum (38; 43; 51) teilweise durch die Struktur (30) und teilweise durch Fotolack (39; 42; 50) definiert wird.

19. Verfahren nach Anspruch 18, **dadurch gekennzeichnet, dass** der Schritt des Elektroformens des genannten Elements (26) darin besteht, das genannte Material in einem Hohlraum (43) zu deponieren, welcher durch die Struktur (28) und durch außen an der Struktur (28) gebildeten Fotolack (42) definiert wird, so dass nach Entfernen des Fotolacks (42) ein Element (26) auf einer Umfangsfläche (27) der Struktur (28) gebildet wird.

20. Anwendung des Verfahrens nach einem beliebigen der Ansprüche 12 bis 19 auf die Herstellung einer Unruh (1), wobei das genannte Element (3) an den Umfang der Struktur (2) platziert wird und dazu dient, das Verhältnis Trägheit/Masse der Unruh zu vergrößern.

21. Anwendung des Verfahrens nach einem beliebigen der Ansprüche 12 bis 19 auf die Herstellung einer Schwungmasse (12; 25) für den automatischen Aufzug, wobei das genannte Element (14; 26) an den Umfang der Struktur (13; 28) platziert wird und dazu dient, das Verhältnis Unwucht/Masse der Schwungmasse zu vergrößern.

22. Verfahren nach Anspruch 18, **dadurch gekennzeichnet, dass** der Schritt des Elektroformens des genannten Elements (22) darin besteht, das genannte Material in einem Hohlraum (38) der Struktur (30) zu deponieren, welcher in seinem zentralen Teil Fotolack (39) aufweist, so dass nach Entfernen des Fotolacks (39) ein Element (22) in dem Hohlraum gebildet wird, welches ein zentrales Loch (23) umfasst.

23. Verfahren nach Anspruch 18 oder 22, **dadurch gekennzeichnet, dass** sich der Hohlraum (51) außerhalb der Ebene der Struktur (30) erstreckt und so beschaffen ist, dass nach dem Schritt des Elektroformens des genannten Elementes (22a) Letzteres ein Zahnrad (22b), eine Kurvenscheibe oder ein Chronographen-Nullstellherz definiert.

24. Anwendung des Verfahrens nach Anspruch 22 oder nach den Ansprüchen 22 und 23 auf die Herstellung einer Uhrenkomponente (20), welche dazu bestimmt ist, auf ein Halteorgan getrieben zu werden, wobei das zentrale Loch (23) des genannten Elementes (22) dazu dient, das Halteorgan aufzunehmen.

25. Anwendung des Verfahrens nach Anspruch 24, **dadurch gekennzeichnet, dass** die Uhrenkomponente eine Unruh, eine Schwungmasse oder ein Rad ist.

## Claims

1. Timepiece component comprising a structure (2; 13; 21; 28) which can be formed by a micro-manufacturing technique and at least one element (3; 14; 22; 26) made of a material different from that of the structure, the material of said element being metallic, **characterised in that** said element is electroformed in the structure or at the periphery of the structure.

2. Timepiece component as claimed in Claim 1, **characterised in that** the structure is of silicon.

3. Timepiece component as claimed in Claim 1, **characterised in that** the structure is of diamond, quartz, glass or silicon carbide.

4. Timepiece component as claimed in any one of Claims 1 to 3, **characterised in that** said element (3; 14; 22) fills a cavity in the structure (2; 13; 21).

5. Timepiece component as claimed in any one of Claims 1 to 4, **characterised in that** said element (3; 14; 22; 26) is in a same plane and has the same height as the structure (2; 13; 21; 28).

6. Timepiece component as claimed in any one of Claims 1 to 4, **characterised in that** said element (22a, 22b) protrudes beyond the plane of the structure (30).

7. Timepiece component as claimed in any one of Claims 1 to 6, **characterised in that** it consists of a balance (1), and **in that** said element (3) is located at the periphery of the structure (2) and is used to increase the inertia/mass ratio of the balance.

8. Timepiece component as claimed in any one of Claims 1 to 6, **characterised in that** it consists of an oscillating mass (12; 25) for an automatic winding mechanism, and **in that** said element (14; 26) is located at the periphery of the structure (13; 28) and is used to increase the unbalance/mass ratio of the oscillating mass.

9. Timepiece component as claimed in any one of Claims 1 to 6, **characterised in that** it is intended to be driven onto a support member, and **in that** said element (22) comprises a central hole (23) intended to receive this support member.

10. Timepiece component as claimed in Claims 6 and 9, **characterised in that** said element (22a) defines a pinion (22b), a cam or a chronograph heart-piece outside the plane of the structure (30).

11. Timepiece component as claimed in Claim 9 or 10, **characterised in that** it consists of a balance (1), an oscillating mass or a wheel (20).

12. Method of manufacturing a timepiece component, comprising a step of forming a structure (2; 13; 21; 28) by a micro-manufacturing technique, **characterised in that** it further comprises a step consisting of electro forming at least one element (3; 14; 22; 26) in the structure or at the periphery of the structure, said element being metallic and of a material different from that of the structure, such that the final timepiece component comprises said structure and said element.

13. Method as claimed in Claim 12, **characterised in that** the step of forming the structure is effected using the DRIE technique.

14. Method as claimed in Claim 12 or 13, **characterised in that** the structure is formed from silicon.

15. Method as claimed in Claim 12 or 13, **characterised in that** the structure is formed from diamond, quartz, glass or silicon carbide.

16. Method as claimed in any one of Claims 12 to 15, **characterised in that** the step of electro forming said element consists of depositing said material in a cavity (31; 38; 43; 51) at least partly defined by the structure (30), using said cavity as a mould.

17. Method as claimed in Claim 16, **characterised in that** the cavity (31) is wholly defined by the structure (30).

18. Method as claimed in Claim 16, **characterised in that** the cavity (38; 43; 51) is defined partially by the structure (30) and partially by photosensitive resin (39; 42; 50).

19. Method as claimed in Claim 18, **characterised in that** the step of electroforming said element (26) consists of depositing said material in a cavity (43) defined by the structure (28) and by photosensitive resin (42) formed on the outside of the structure (28) such that after removal of the photosensitive resin (42) an element (26) is formed on a peripheral surface (27) of the structure (28).

20. Application of the method as claimed in any one of Claims 12 to 19 to the manufacture of a balance (1), said element (3) being placed at the periphery of the structure (2) and being used to increase the inertia/mass ratio of the balance.

21. Application of the method as claimed in any one of Claims 12 to 19 to the manufacture of an oscillating mass (12; 25) for an automatic winding mechanism, said element (14; 26) being placed at the periphery of the structure (13; 28) and being used to increase the unbalance/mass ratio of the oscillating mass.

22. Method as claimed in Claim 18, **characterised in that** the step of electroforming said element (22) consists of depositing said material in a cavity (38) in the structure (30) comprising photosensitive resin (39) in its central part, such that after removal of the photosensitive resin (39) an element (22) comprising a central hole (23) is formed in the cavity.

23. Method as claimed in Claim 18 or 22, **characterised in that** the cavity (51) extends outside the plane of the structure (30) and is shaped such that after the step of electroforming said element (22a) this element defines a pinion (22b), a cam or a chronograph heart-piece.

24. Application of the method as claimed in Claim 22 or as claimed in Claims 22 and 23 to the manufacture of a timepiece component (20) intended to be driven on a support member, the central hole (23) of said element (22) being used to receive the support member.

25. Application as claimed in Claim 24, **characterised in that** the timepiece component is a balance, an oscillating mass or a wheel.
